# FASCICULE DE BREVET EUROPEEN

(11) **EP 4 371 032 B1**
(45) Date de publication et mention de la délivrance du brevet: **31.12.2025**
(21) Numéro de dépôt: 22750801.7
(22) Date de dépôt: 11.07.2022
(51) Int. Cl.: G06K 19/077

(54) **PROCÉDÉ DE FABRICATION DE CIRCUITS IMPRIMÉS MULTICOLORES POUR MODULES DE CARTE À PUCE**
VERFAHREN ZUR HERSTELLUNG MEHRFARBIGER LEITERPLATTEN FÜR CHIPKARTENMODULE
METHOD FOR MANUFACTURING MULTICOLOURED PRINTED CIRCUITS FOR SMART CARD MODULES

(30) Priorité: 16.07.2021 FR 2107729
(43) Date de publication de la demande: 22.05.2024
(73) Titulaire: Linxens Holding, 78200 Mantes-la-Jolie (FR)
(72) Inventeur: COPPOLA, Mara, 78200 Mantes-La-Jolie (FR); MICHAUDET, Nicolas, 78200 Mantes-La-Jolie (FR); GLARIS, Patrice, 78200 Mantes-La-Jolie (FR)
(74) Mandataire: INNOV-GROUP
(86) Numéro de dépôt international: PCT/EP2022/069345
(87) Numéro de publication internationale: WO 2023/285395

(56) Documents cités:
- WO-A1-97/31323
- DE-A1- 19 523 242
- US-A- 5 688 573
- US-A1- 2020 250 504
- US-B1- 6 259 035

## Description

### Domaine technique

L'invention concerne le domaine des modules électroniques pour carte à puce et des procédés de fabrication de circuits imprimés flexibles utilisés pour réaliser des modules électroniques pour carte à puce.

### Art antérieur

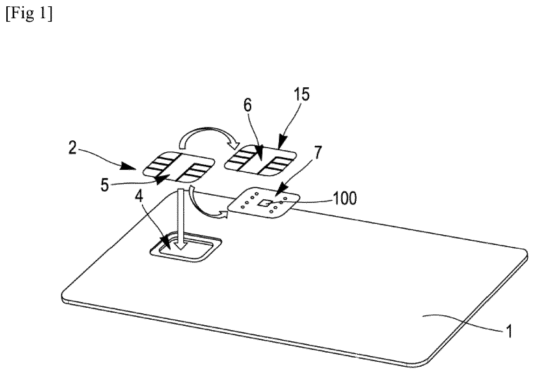

Comme représenté sur la figure 1, les cartes à puce sont généralement constituées d'un support rigide 1 en matière plastique de type PVC, PVC/ABS ou polycarbonate constituant l'essentiel de la carte, avec une cavité 4 dans laquelle est incorporé un module électronique 2 fabriqué séparément. Sur la figure 1, le module 2 est également représenté vu par sa face avant 6 (en haut) et retourné pour voir sa face arrière 7 (en bas). Ce module électronique 2 comporte une puce électronique 100 (circuit intégré). Des moyens de transmission permettent de transmettre des données de la puce 100 à un dispositif lecteur de carte (lecture) ou de ce dispositif à la carte (écriture). Ces moyens de transmission de données peuvent être « à contact », « sans contact » ou bien « dual » lorsqu'ils combinent les deux moyens précédents. Dans une carte à puce « à contact », un connecteur 5, formé à partir d'un circuit imprimé, comporte sur la face avant 6 du connecteur 5, des plages de contact 15 électriquement connectées à la puce 100 et affleurant, en surface du support de carte 1, pour une connexion par contact électrique avec un dispositif lecteur de carte. Dans une carte à puce « dual», en plus du connecteur 5, au moins une antenne est prévue, généralement dans le corps de carte, pour une connexion sans contact avec un dispositif lecteur de carte (en outre, la carte à puce comporte des moyens de connexion inductifs ou électriques pour établir une communication entre l'antenne et la puce supportée par le module 2). Dans ce document, nous nous intéresserons essentiellement aux modules 2 pour cartes à puce « à contact » ou « dual ».

Dans l'art antérieur, les modules 2 de carte à puce sont généralement formés à partir d'un substrat diélectrique recouvert, sur au moins l'une de ses faces 6, 7, d'une feuille de matériau électriquement conducteur, constituée par exemple d'un métal tel que du cuivre, de l'acier ou de l'aluminium ou un alliage de l'un de ces métaux. Dans cette feuille de matériau électriquement conducteur sont réalisées des pistes conductrices formant, pour certaines, au moins sur la face avant 6, les plages de contacts électriques 15. Les substrats diélectriques utilisés dans l'art antérieur sont réalisés en matériaux composites (verre-époxy) ou en matériaux plastiques (PET, PEN, polyimide, etc.). Ce type de substrat diélectrique est généralement mince (son épaisseur est par exemple de l'ordre de 100 µm) pour conserver une flexibilité compatible avec des procédés de fabrication de modules électroniques en continu (de bobine à bobine, c'est-à-dire « reel-to-reel » ou « roll-to-roll » en anglais).

Dans un procédé de fabrication de circuits imprimés flexibles pour modules de carte à puce, on fournit un matériau complexe formé de plusieurs couches ou feuillets empilés et assemblés selon la direction correspondant à sa plus petite dimension (c'est-à-dire son épaisseur). Ce matériau complexe présente donc une forme de planche mince ou de bande, avec deux faces principales. Cette planche mince ou cette bande est flexible de manière à pouvoir être courbée selon une direction perpendiculaire à ses faces principales et, notamment, être compatible avec un procédé de fabrication en continu.

Le matériau complexe forme un ensemble comprenant au moins deux strates de matériau diélectrique de couleurs différentes. Par exemple, cet ensemble comporte au moins un substrat diélectrique avec au moins une couche de matériau diélectrique déposée sur l'une des faces principales du substrat diélectrique. Au moins une couche de matériau électriquement conducteur repose sur l'ensemble comprenant au moins deux strates de matériau diélectrique de couleurs différentes (le matériau complexe peut en effet comporter, par exemple, une couche de matériau électriquement conducteur en face avant et une couche de matériau électriquement conducteur en face arrière).

Dans ce matériau complexe, des contacts sont réalisés dans la couche de matériau électriquement conducteur. Ces contacts sont destinés à établir une connexion électrique avec un lecteur de cartes à puce. Il en résulte qu'au moins entre ces contacts, l'ensemble comprenant au moins deux strates de matériau diélectrique de couleurs différentes est apparent sur au moins une zone qui correspond à l'espace nécessaire entre les contacts pour les isoler les uns des autres. La zone apparente peut également correspondre à un espace gravé dans la couche de matériau électriquement conducteur pour former un motif tel qu'un logo par exemple.

Selon un exemple, dans l'ensemble comprenant au moins deux strates de matériau diélectrique de couleurs différentes, le substrat et la ou les couches de matériau diélectrique supplémentaires forment chacun une strate de matériau diélectrique. Dans ce document, une « strate » (c'est-à-dire une strate de matériau diélectrique) peut être constituée d'une couche de matériau diélectrique adhésif ou non, du substrat diélectrique lui-même, d'une couche de renfort, etc. Ainsi bien que la ou les couches de matériau électriquement conducteur fassent partie du matériau complexe, elles ne constituent pas des strates colorées de matériau diélectrique au sens de ce document.

Le document FR3040516A1 décrit un procédé dans lequel les contacts sont réalisés dans une couche de matériau électriquement conducteur en laissant apparaître une couche de matériau adhésif teinté sous-jacente à la couche de matériau électriquement conducteur. Dans ce cas, la couche de matériau adhésif teinté repose par exemple sur un substrat diélectrique. Ce document de l'art antérieur divulgue donc un matériau complexe avec deux strates de couleurs différentes : la couleur du substrat diélectrique et la couleur de la couche d'adhésif teinté. Cependant, la couche d'adhésif teinté recouvrant le substrat diélectrique, seule la couleur de la couche d'adhésif teinté est visible à travers les espaces ménagés dans la couche de matériau électriquement conducteur. Le document DE19523242A1 décrit un module de carte à puce avec des motifs colorés afin d'ajouter une sécurité supplémentaire contre la falsification.

Pour proposer des modules avec des motifs colorés plus complexes, les inventeurs ont cherché à obtenir plus de couleurs dans la ou les zones apparentes à travers les espaces ou découpes réalisés dans la couche de matériau électriquement conducteur.

### Brève description de l'invention

A cette fin, les inventeurs proposent d'ajouter aux procédés de l'art antérieur au moins une opération consistant à graver, sur une portion de la zone laissée apparente de l'ensemble comprenant au moins deux strates de matériau diélectrique de couleurs différentes, au moins l'une des deux strates de couleurs différentes, à l'aide d'un faisceau laser, de manière à rendre visible la couleur de l'autre des deux strates de couleurs différentes.

Autrement dit, sur une zone laissée apparente à travers la couche de matériau électriquement conducteur, une partie d'une couche ou strate colorée sous-jacente à la couche de matériau électriquement conducteur est retirée à l'aide d'un faisceau laser, de manière à faire apparaître une autre couleur correspondant à une autre couche ou strate colorée située sous celle sous-jacente à la couche de matériau électriquement conducteur.

On peut ainsi créer des motifs présentant au moins deux couleurs différentes (en plus de la couleur de la couche de matériau électriquement conducteur elle-même).

On peut noter que ces couleurs ne sont pas nécessairement visibles à la lumière du jour. En effet, les couleurs peuvent provenir d'agents photochromes sensibles à des lumières ayant des longueurs d'onde par exemple dans l'ultra-violet ou l'infra-rouge. On peut se référer par exemple au document FR3063414A1 pour avoir des exemples d'agents photochromes. Les différentes couleurs des strates sous-jacentes à la couche de matériau électriquement conducteur sont alors révélées lors d'une exposition du module à ces longueurs d'onde particulières. Ce type de propriétés peut être utilisé notamment pour prévenir, ou au moins rendre plus difficile, la falsification des modules de cartes à puce.

Les couleurs peuvent provenir d'agents thermochromes sensibles à la chaleur. De tels agents peuvent changer de couleur, de manière permanente ou non, en fonction de la température.

Ainsi, dans ce document, la couleur des strates de couleurs différentes peut provenir soit de la couleur originelle du matériau qui constitue chacune de ces strates, soit d'un agent, d'une substance ou d'un matériau colorant, soit d'un agent, d'une substance ou d'un matériau photochrome (par exemple, un agent, une substance ou un matériau fluorescent ou phosphorescent), soit d'un agent, d'une substance ou d'un matériau thermochrome. L'agent, la substance ou le matériau colorant, photochrome ou thermochrome peut être un « colorant » ou un « pigment ». Dans ce document, on nomme
- « colorant » (« dye » en anglais), une matière soluble dans le milieu (par exemple le matériau de la couche de matériau diélectrique et éventuellement adhésif) dans lequel il est introduit (on dit que le colorant est dissous dans le milieu) ;
- « pigment », une matière insoluble dans le milieu (par exemple le matériau de la couche de matériau diélectrique et éventuellement adhésif) dans lequel il est introduit (on dit que le pigment est dispersé dans le milieu).

Le procédé selon l'invention comporte éventuellement en outre l'une ou l'autre des caractéristiques suivantes, considérées chacune individuellement ou en combinaison d'une ou plusieurs autres :
- la zone de l'ensemble comprenant au moins deux strates de matériau diélectrique de couleurs différentes laissée apparente est obtenue par photolithographie et gravure électrochimique de la couche de matériau électriquement conducteur ; alternativement ou en complément, la zone de l'ensemble comprenant au moins deux strates de matériau diélectrique de couleurs différentes laissée apparente est obtenue par gravure, à l'aide d'un faisceau laser, de la couche de matériau électriquement conducteur ; et
- le procédé comprend une étape de perforation de trous dans l'ensemble comprenant au moins deux strates de matériau diélectrique de couleurs différentes, préalablement à une étape de lamination de la couche de matériau électriquement conducteur, au cours de laquelle au moins certains des trous sont au moins partiellement obturés par la couche de matériau électriquement conducteur, pour former des trous borgnes ou des vias conducteurs ; alternativement, la couche de matériau électriquement conducteur est colaminée avec l'ensemble comprenant au moins deux strates de matériau diélectrique de couleurs différentes et au moins certains des trous sont réalisés à travers l'ensemble des strates à l'aide d'un faisceau laser, à partir de la surface libre du substrat diélectrique et en arrêtant la perforation au laser lorsque la couche de de matériau électriquement conducteur est atteinte.

Selon la nature, le nombre et/ou l'épaisseur des différentes strates superposées, notamment si ces strates sont formées d'un matériau adhésif, peut se poser un problème de fluage du matériau adhésif dans les trous. Ceci peut compromettre une connexion fiable d'un fil de connexion (par la technique du micro-câblage - « wire bonding » en anglais) sur la face interne de la couche de matériau électriquement conducteur, au fond des trous borgnes. Ce problème de fluage peut également compromettre la connexion avec la couche de matériau électriquement conducteur lorsqu'une couche conductrice est déposée par électrodéposition sur la paroi des trous (technique du via conducteur - « plated through hole » en anglais). Ce problème est éventuellement au moins en partie résolu en déposant une couche de renfort entre deux strates, par exemple entre le substrat diélectrique et au moins l'une des couches de matériau adhésif.

L'invention concerne également un circuit imprimé flexible, pour module de carte à puce, selon la revendication 7.

Ce circuit imprimé comporte dans l'une des deux zones laissées apparentes, au moins une couleur, et dans l'autre des deux zones laissées apparentes, au moins une autre couleur.

Le circuit imprimé selon l'invention comporte éventuellement en outre l'une ou l'autre des caractéristiques suivantes, considérées chacune individuellement ou en combinaison d'une ou plusieurs autres :
- le matériau complexe comprend un substrat diélectrique flexible et au moins une couche de matériau diélectrique adhésif reposant sur le substrat diélectrique ;
- le matériau complexe comprend un substrat diélectrique flexible, au moins une couche de matériau diélectrique adhésif et au moins une couche de renfort intercalé entre le substrat diélectrique flexible et la couche de matériau diélectrique adhésif
- le matériau complexe comprend au moins deux couches de matériau diélectrique adhésif de couleurs apparentes différentes ; et
- chaque couche de matériau diélectrique adhésif a une épaisseur supérieure ou égale à 7 micromètres ; par exemple, chaque couche de matériau diélectrique adhésif a une épaisseur supérieure ou égale à 10 micromètres (avec une tolérance de plus ou moins 3 micromètres) et éventuellement inférieure ou égale à 20 micromètres (avec une tolérance de plus ou moins 3 micromètres).

Selon encore un autre aspect, l'invention concerne un module de carte à puce comprenant un circuit imprimé selon l'invention. Un tel module comporte notamment une puce électronique et des trous perforés à travers l'épaisseur de l'ensemble comprenant le substrat et la ou les couches de matériau diélectrique. Ces trous sont au moins partiellement obturés par la couche de matériau électriquement conducteur. La puce est connectée par l'intermédiaire de ces trous (trous borgnes ou vias conducteurs) à des contacts réalisés dans la couche de matériau électriquement conducteur. Eventuellement, le matériau complexe comporte plus d'une couche de matériau diélectrique adhésif, chaque couche de matériau diélectrique adhésif ayant une couleur différente.

Selon encore un autre aspect, l'invention concerne une carte à puce comprenant un corps de carte, une cavité formée dans le corps de carte et un module logé dans la cavité. Ce module comprend alors un circuit imprimé selon l'invention et l'épaisseur totale du module (Y compris le matériau d'encapsulation enrobant la puce et ses éventuelles connexions aux contacts) est inférieure ou égale à 580µm. Cette épaisseur peut être par exemple inférieure ou sensiblement égale à 540µm.

### Brève description des figures

D'autres caractéristiques et avantages de l'invention apparaîtront à la lecture de la description détaillée et des dessins annexés sur lesquels :
- La figure 1 représente schématiquement en perspective une carte à puce destinée à recevoir un module comprenant un circuit imprimé ;
- Les figures 2a à 2l représentent schématiquement et successivement différentes étapes d'un exemple de procédé de fabrication d'un circuit imprimé ;
- La figure 3 illustre schématiquement en coupe un exemple d'étape de gravure de strates, à l'aide d'un faisceau laser ;
- La figure 4 illustre schématiquement en coupe un autre exemple d'étape de gravure de strates, à l'aide d'un faisceau laser ;
- La figure 5 illustre schématiquement en coupe un exemple de strates gravées, à l'aide d'un faisceau laser ; et
- la figure 6 représente schématiquement, un exemple de module obtenu par un procédé tel que ceux décrits en relation avec les figures 2 à 5.

### Description détaillée

Un exemple de procédé de fabrication, selon l'invention, d'un circuit imprimé pour module de carte à puce est décrit ci-dessous.

Comme représenté sur la figure 1, une carte à puce 1 comporte un module 2. Le module 2 comprend un connecteur 5 formé à partir d'un circuit imprimé flexible. Ce connecteur est muni d'une puce 100. Le module 2 est généralement réalisé sous forme d'un élément séparé qui est inséré dans une cavité 4 ménagée dans la carte 1. Si la carte à puce est une carte « dual », le module 2 est éventuellement connecté à une antenne lors de son insertion dans la cavité 4. Alternativement, toujours dans le cas d'une carte « dual », le module 2 comporte une antenne destinée à être inductivement couplée à une autre antenne intégrée dans le corps de la carte à puce 1.

Le connecteur 5 comporte plusieurs plages de contact 15 auxquelles est connectée la puce 100. Le connecteur 5 est représenté (en haut) vu par sa face avant 6 (face contact). Il est aussi représenté (en bas) vu par sa face arrière 7 ou face de liaison (« bonding side » selon la terminologie anglo-saxonne). Le connecteur 5 ainsi représenté correspond à un connecteur 5 simple face pour carte « à contact ». Mais il pourrait tout aussi bien s'agir d'un connecteur 5 simple ou double face, pour carte « dual » par exemple.

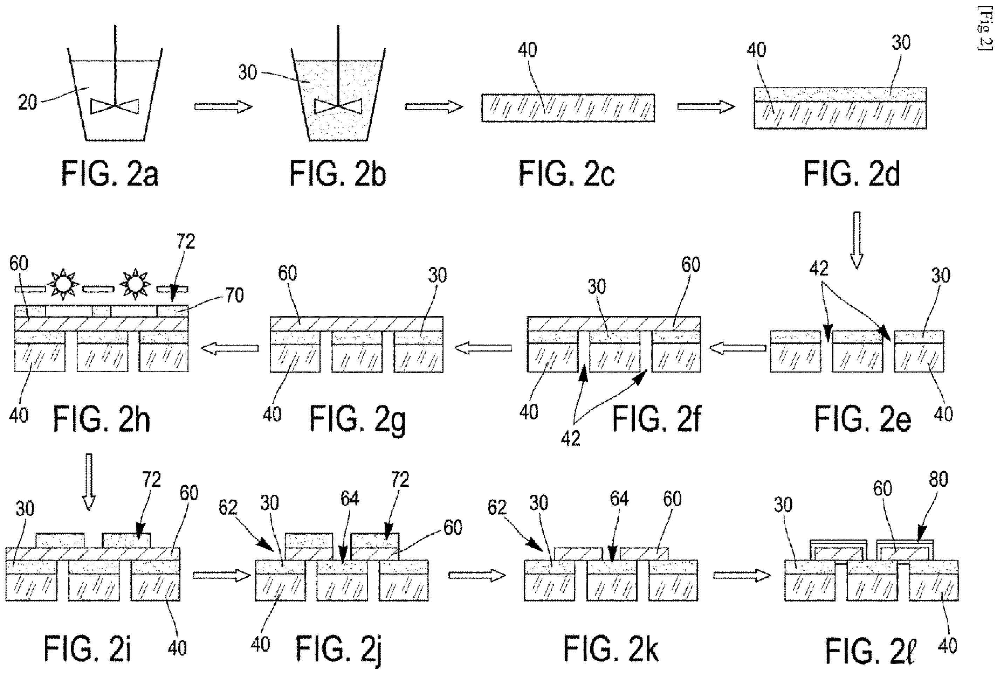

Les figures 2a à 2l illustrent schématiquement différentes étapes d'un exemple de mise en œuvre d'un procédé pour la fabrication du circuit imprimé flexible.

Ce procédé comprend la fourniture (Fig. 2a) d'un matériau diélectrique adhésif ou colle 20, sous forme liquide. Le matériau diélectrique adhésif 20 est par exemple constitué d'une résine epoxy, éventuellement modifiée. A ce stade, le matériau diélectrique adhésif 20 est par exemple naturellement de couleur jaune clair et transparente.

A l'étape suivante (Fig. 2b), un agent colorant (c'est-à-dire un « colorant » ou un « pigment » tels que définis ci-dessus) est adjoint au matériau diélectrique adhésif 20 pré-formulé. Selon la nature de l'agent colorant, le matériau diélectrique adhésif 20 est coloré ou non. En effet, l'agent colorant peut ne pas colorer le matériau diélectrique adhésif 20 sans activation photonique. Cet agent colorant peut être organique ou inorganique. Il peut teinter le matériau diélectrique adhésif 20 par exemple en rouge, magenta, bleu, vert, orange, gris, noir, etc. ou ne pas apporter de coloration lorsqu'il est éclairé par une lumière dont le spectre est situé dans le visible. Si l'agent colorant est de nature pigmentaire, il peut s'agir d'un pigment ou d'un mélange de plusieurs pigments, en poudre ou en pré-dispersion pigmentaire (également avec un ou plusieurs pigments). Par exemple, il peut s'agir d'une encre telle que celles utilisées pour la fabrication de billets de banque.

A l'étape suivante (Fig. 2c), on fournit un substrat diélectrique 40 (Fig. 2c). Le substrat diélectrique 40 est destiné à former une strate d'une couleur. Le matériau du substrat diélectrique 40 est par exemple du verre-époxy. Il peut être opaque ou transparent. L'utilisation d'un substrat opaque permet éventuellement de masquer la puce 100 et son câblage sous-jacents à la zone que l'on souhaite voir colorée. Ce matériau diélectrique 40 est généralement commercialisé en couleur noire, grise, jaune, verte ou blanche par exemple. D'autres couleurs peuvent éventuellement être obtenues. Son épaisseur est par exemple voisine de 100µm.

A l'étape suivante (Fig. 2d), le substrat diélectrique 40 est enduit avec le matériau diélectrique adhésif obtenu à l'étape correspondant à la figure 2b. Une première couche de matériau diélectrique 30 est ainsi formée. La première couche de matériau diélectrique 30 est destiné à former une strate d'une couleur différente de celle du substrat diélectrique 40. Elle a, par exemple, une épaisseur comprise entre 10 et 70µm après séchage, et plus préférentiellement entre 10 et 20µm après séchage, par exemple elle a une épaisseur de 15µm, à 3µm près.

Après séchage, l'ensemble constitué du substrat diélectrique 40 et de la première couche de matériau diélectrique 30 est perforé de part en part (Fig. 2e), par exemple mécaniquement par poinçonnage, pour former des trous 42 correspondant à des puits de connexion et éventuellement des ouvertures pour recevoir un ou plusieurs composants électroniques.

Une feuille de matériau électriquement conducteur est mise au contact de la première couche de matériau diélectrique 30 (Fig. 2f). Cette feuille forme ainsi une couche de matériau électriquement conducteur 60 reposant sur le substrat 40. La couche de matériau électriquement conducteur 60 recouvre des trous 42. L'ensemble constitué de la couche de matériau électriquement conducteur 60, de la première couche de matériau diélectrique 30 et du substrat diélectrique 40 est laminé pour former un matériau complexe. La première couche de matériau diélectrique 30 est réticulée en étuve (Fig. 2g).

Des motifs en résine 72 sont réalisés par photolithographie sur la couche de matériau électriquement conducteur 60, par dépôt, insolation (Fig. 2h) et révélation d'une résine photosensible 70 (Fig. 2i).

Une étape de gravure de motifs par voie électrochimique permet de réaliser des motifs 62 dans la couche de matériau électriquement conducteur 60 (Fig. 2j), correspondant à ceux définis par la résine 72 à l'étape précédente. Des espaces 64 entre les différents éléments des motifs 62 (contacts, logos, etc.) sont gravés dans la couche de matériau électriquement conducteur 60 et la couche de matériau adhésif 30 devient apparente dans ces espaces 64.

La résine protégeant les motifs 62 pendant la gravure est retirée (Fig. 2k) et des couches de finition 80 (Nickel et Or par exemple), sont éventuellement déposées sur la face avant 6 par électrodéposition sur au moins une partie des motifs 62 (Fig. 2l).

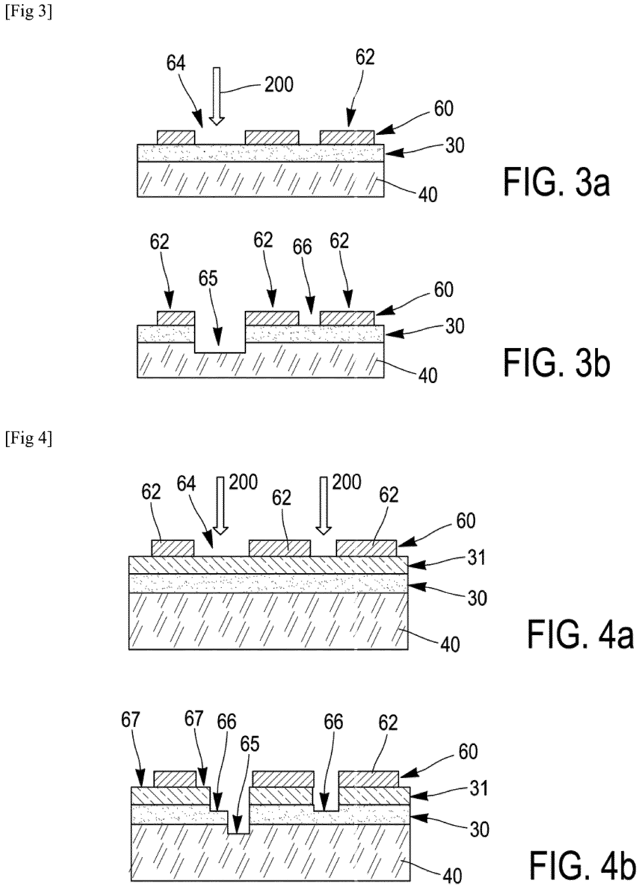

Au cours d'une étape illustrée par la figure 3, une portion de la strate formée de la couche de matériau diélectrique 30 est retirée sur toute son épaisseur par exemple au niveau de l'un des espaces 64, à l'aide d'un faisceau laser 200 (voir figure 3a). Le faisceau laser 200 est par exemple un laser UV, émettant par exemple à 355 nm. Le faisceau laser a par exemple une puissance comprise entre 1 et 10 Watts. Par exemple, sa puissance est de 2 watts pour le laser UV mentionné ci-dessus. Il émet un faisceau dont la fréquence est par exemple comprise entre 40 et 140 kHz. Par exemple, cette fréquence est de 80 kHz pour le laser UV mentionné ci-dessus. Le pas des impulsions laser est par exemple de 10 micromètres pour le laser UV mentionné ci-dessus. Le diamètre du faisceau est par exemple compris entre 3 et 50 micromètres. Par exemple, ce diamètre est de 40 micromètres pour le laser UV mentionné ci-dessus. On peut noter qu'un laser UV est plus adapté à la gravure de motifs fins (entre les plages de contacts 15) qu'un laser infra-rouge par exemple. Cependant, lorsque les couches et strates à graver sont formées d'un matériau organique, un laser infra-rouge peut être adapté. Dans ce cas, le laser IR émet par exemple à 1065 nm et le diamètre de son faisceau est par exemple compris entre 80 et 300 micromètres. Une partie de l'épaisseur du substrat diélectrique 40 est éventuellement également éliminée pour bien révéler sa couleur (c'est-à-dire pour ne pas laisser de matériau diélectrique qui est d'une autre couleur). On obtient alors, entre des motifs 62, une zone 65 ayant la couleur correspondant à celle du substrat diélectrique 40 et, entre d'autres motifs 62, une zone 66 ayant la couleur correspondant à celle de la première couche de matériau diélectrique 30 (voir figure 3b). Au niveau de la zone 65, sur la figure 3b, le matériau diélectrique 30 a été retiré sur toute la surface comprise entre les motifs 62. Selon une variante non illustrée, seule une portion de cette surface aurait pu être retirée (en utilisant un faisceau laser plus fin et/ou en balayant une moindre surface avec le faisceau, par exemple), de manière à obtenir une zone 65 bicolore.

Au cours d'étapes non-illustrées, une puce 100 est fixée en face arrière de chaque module. Chaque puce 100 est connectée, par exemple par des fils conducteurs, à travers des puits de connexion (comme les trous 42), au fond de ceux-ci, à des contacts 15 (voir figure 1). La puce et les fils conducteurs sont encapsulés et les modules sont individualisés et reportés, chacun individuellement dans une cavité 4 de la carte 1.

Selon un autre mode de mise en œuvre du procédé selon l'invention, celui-ci comporte une autre étape d'enduction avec un matériau adhésif de manière à former une deuxième couche de matériau diélectrique 31. Cette deuxième couche de matériau diélectrique 31 forme une strate d'une autre couleur que celle de la première couche de matériau diélectrique 30. Autrement dit, après l'étape décrite ci-dessus en relation avec la Fig. 2d, une deuxième couche de matériau diélectrique 31 est déposée sur la première couche de matériau diélectrique 30 recouvrant déjà au moins partiellement le substrat diélectrique 40. La deuxième couche de matériau diélectrique 31 a, par exemple, une épaisseur comprise entre 10 et 70µm après séchage, et plus préférentiellement entre 10 et 20µm après séchage, par exemple elle a une épaisseur de 15µm, à 3µm près. Le matériau de la deuxième couche de matériau diélectrique 31 est obtenu par exemple selon un procédé similaire ou identique à celui déjà décrit ci-dessus en relation avec les figures 2a et 2b.

La deuxième couche de matériau diélectrique 31 a une couleur différente de celle de la première couche de matériau diélectrique 30 qui lui est sous-jacente et éventuellement également différente de celle du substrat diélectrique 40. On obtient ainsi éventuellement trois strates de couleurs différentes. Selon la nature respective des matériaux des couches de matériau diélectrique 30, 31, la deuxième couche de matériau diélectrique 31 est déposée sur une couche de matériau diélectrique 30 déjà réticulée ou non.

Des étapes semblables ou identiques à celles décrites ci-dessus en relation avec les figures 2e à 2l sont ensuite mises en œuvre.

De manière similaire à l'étape décrite ci-dessus en relation avec la figure 3, une portion de la deuxième couche de matériau diélectrique 31 est retirée par exemple au niveau d'un espace 64, à l'aide d'un faisceau laser 200 (voir figure 4a). Le faisceau laser 200 a par exemple les mêmes propriétés et paramètres que ceux indiqués ci-dessus en relation avec la description de la figure 3. On obtient alors, entre des motifs 62, des zones 66 ayant la couleur correspondant à celle de la première couche de matériau diélectrique 30 et, entre d'autres motifs 62, des zones 67 ayant la couleur correspondant à celle de la deuxième couche de matériau diélectrique 31. Puis au niveau d'au moins l'une des zones 66 sur lesquelles une portion de la deuxième couche de matériau diélectrique 31 a déjà été retirée, une portion de la première couche de matériau diélectrique 30 est retirée sur toute son épaisseur, pour découvrir le substrat diélectrique 40 sous-jacent. On obtient alors des zones 65 ayant la couleur correspondant à celle du substrat diélectrique 40. Pour chacune de ces gravures à l'aide du faisceau laser 200, une partie de l'épaisseur de la couche dont on souhaite voir la couleur est éventuellement éliminée pour bien révéler sa couleur (c'est-à-dire pour ne pas laisser de matériau diélectrique d'une autre couleur).

Sur la figure 4b, est représentée une zone entre des motifs 62 au niveau de laquelle apparaissent les trois couleurs, respectivement du substrat diélectrique 40, de la première couche de matériau diélectrique 30 et de la deuxième couche de matériau diélectrique 31. Mais de nombreuses variantes peuvent être envisagées dans lesquels une ou deux seulement de ces trois couleurs sont révélées par gravure à l'aide du faisceau laser 200.

Comme précédemment, au cours d'étapes non-illustrées, une puce 100 est fixée en face arrière de chaque module. Chaque puce 100 est connectée, par exemple par des fils conducteurs, à travers des puits de connexion (comme les trous 42), au fond de ceux-ci, à des contacts 15. La puce et les fils conducteurs sont encapsulés et les modules sont individualisés et reportés, chacun individuellement dans une cavité 4 de la carte 1.

Selon encore un autre mode de mise en œuvre du procédé selon l'invention, il est prévu, entre les étapes décrites en relation respectivement avec les figures 2c et 2d, de déposer sur le substrat diélectrique 40, une couche de renfort 68 avant de l'enduire d'une ou plusieurs couches de matériau diélectrique 30, 31. La couche de renfort 68 est par exemple constituée, comme la ou les couches de matériau diélectrique 30, 31 d'une résine phénolique ou époxy. La couche de renfort 68 est éventuellement en outre chargée de billes de verre ou de silice. Son épaisseur est par exemple comprise entre 10 et 20 micromètres, à plus ou moins 3 micromètres près. La couche de renfort 68 peut être elle-même une couche de matériau diélectrique adhésif ayant des propriétés rhéologiques lui permettant de ne pas fluer ou de peu fluer lors de la lamination de l'ensemble des couches formant le matériau complexe. La couche de renfort 68 peut être réticulée aux UV, afin d'obtenir un durcissement en ligne conduisant soit à un durcissement intermédiaire ou à un état complètement durci. Ceci permet de limiter le temps d'attente avant de déposer une autre couche dessus. La couche de renfort 68 peut être également colorée, luminescente ou phosphorescente, tout comme les couches de matériau diélectrique 30, 31 ou le substrat diélectrique 40 déjà décrits.

La couche de renfort 68 peut avoir notamment les avantages suivants : elle peut permettre de limiter le nombre de couches de matériau diélectrique 30, 31 en formant elle-même une couche colorée plus rigide ; elle peut également permettre d'écranter au moins partiellement la diffusion de la chaleur (par exemple lors de la lamination de la couche de matériau électriquement conducteur 60) vers la ou les couches de matériau diélectrique 30, 31 et limite ainsi le fluage des couches de matériau diélectrique 30, 31 qui sont davantage susceptibles de fluer sous l'effet de la chaleur. Ceci améliore les propriétés mécaniques du matériau complexe qui résulte de la lamination du substrat diélectrique, de la ou des couches de matériau diélectrique 30, 31, et de la couche de matériau électriquement conducteur 60, en vue de fiabiliser la connexion électrique de la puce aux contacts 15 réalisés dans la couche de matériau électriquement conducteur 60, par l'intermédiaire de trous 42 (trous borgnes ou vias conducteurs).

Les étapes subséquentes (enduction avec la ou les couches de matériau diélectrique adhésif, perforation, formation d'une couche de matériau électriquement conducteur, réticulation de la ou des couches de matériau diélectrique adhésif, formation de contacts et de motifs, gravure à l'aide d'un faisceau laser des couches sous-jacentes à la couche de matériau électriquement conducteur, fixation et connexion d'une puce, encapsulation de la puce, etc.) sont identiques ou similaires à celles décrites ci-dessus.

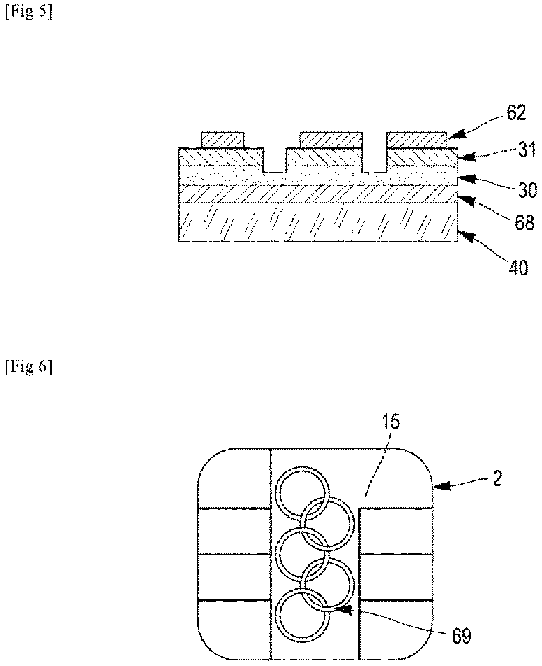

La figure 6 représente schématiquement, un exemple de module 2 de carte à puce obtenu par la mise en œuvre d'un procédé similaire à ceux décrits ci-dessus en relation avec les figures 4 et 5. Ce module est vu par sa face avant. Dans l'un de ces contacts 15, sont réalisés des anneaux 69 correspondant donc à des zones dans lesquelles la couche de matériau électriquement conducteur a été retirée (procédé électrochimique ou par faisceau laser) pour faire apparaitre la couche de matériau diélectrique sous-jacente. Puis, les différentes strates de matériau diélectrique adhésif, de renfort et/ou de substrat diélectrique sont gravées à l'aide d'un faisceau laser afin d'obtenir les couleurs bleue, jaune, noire, verte et rouge des anneaux olympiques. Bien entendu, de nombreux autres motifs colorés peuvent être obtenus à l'aide du procédé de fabrication de circuits imprimés flexible pour modules de carte à puce, selon l'invention.

Selon d'autres modes de réalisation de l'invention, la révélation de différentes couleurs par gravure à l'aide d'un faisceau laser peut être réalisée sur des substrats multicouches variés. Ainsi, un substrat multicouche peut être obtenu par colamination de plusieurs couches (par exemple 2 ou 3) de préimprégné, chacune de ces couches de préimprégné ayant une couleur différente de celle des autres couches de préimprégné. Par exemple, chaque couche de préimprégné est formée d'une résine epoxy colorée et son épaisseur est comprise entre 50 à et 75 micromètres. Le substrat en résultant a par exemple une épaisseur comprise entre 100 et 150 micromètres. Alternativement, un substrat multicouche peut être obtenu par coextrusion de plusieurs couches. Par exemple, chaque couche est composée d'une matière plastique telle que du PET (Polyéthylène Téréphtalate) coloré et a une épaisseur comprise entre 50 et 75 micromètres.

Quel que soit le mode de réalisation, le matériau complexe comprenant les différentes couches de matériau diélectrique (substrat 40, couches 30, 31, couche de renfort 68, etc.) et la ou les couches de matériau électriquement conducteur 60 a préférentiellement une épaisseur maximale de 250µm (par exemple cette épaisseur est fixée à 227µm+/-20).

## Revendications

1. Procédé de fabrication de circuits imprimés flexibles pour modules (2) de carte à puce (1) dans lequel un matériau complexe est fourni,
ce matériau complexe se présentant sous forme d'une planche mince ou d'une bande, avec deux faces principales et étant flexible de manière à pouvoir être courbé selon une direction perpendiculaire à ses faces principales, ce matériau complexe formant un ensemble comprenant au moins deux strates de matériau diélectrique de couleurs différentes, et
ce matériau complexe comportant en outre au moins une couche de matériau électriquement conducteur (60) au contact d'une strate de l'ensemble comprenant au moins deux strates de matériau diélectrique de couleurs différentes, cette strate comprenant une résine époxy, des contacts (15) étant réalisés dans la couche de matériau électriquement conducteur (60), ces contacts étant destinés à établir une connexion électrique avec un lecteur de cartes à puce, l'ensemble comprenant au moins deux strates de matériau diélectrique de couleurs différentes étant apparent à travers la couche de matériau électriquement conducteur (60) sur au moins une zone (64),
ce procédé de fabrication étant **caractérisé par le fait qu'**il comporte une opération consistant à graver au moins l'une des deux strates de couleurs différentes à l'aide d'un faisceau laser sur une portion de la zone (64, 65, 66, 67) laissée apparente de l'ensemble comprenant au moins deux strates de matériau diélectrique de couleurs différentes, de manière à rendre visible la couleur de l'autre des deux strates de couleurs différentes.

2. Procédé de fabrication de circuits imprimés flexibles pour modules de carte à puce selon la revendication 1, dans lequel l'ensemble comprenant au moins deux strates de matériau diélectrique de couleurs différentes, comporte un substrat diélectrique (40) avec au moins une couche de matériau diélectrique (30, 31) déposée sur l'une des faces principales du substrat diélectrique (40).

3. Procédé de fabrication de circuits imprimés flexibles pour modules de carte à puce selon la revendication 1 ou 2, la zone de l'ensemble comprenant au moins deux strates de matériau diélectrique de couleurs différentes laissée apparente est obtenue par gravure, à l'aide d'un faisceau laser, de la couche de matériau électriquement conducteur.

4. Procédé de fabrication de circuits imprimés flexibles pour modules de carte à puce selon la revendication 1 ou 2, dans lequel la zone de l'ensemble comprenant au moins deux strates de matériau diélectrique de couleurs différentes laissée apparente est obtenue par photolithographie et gravure électrochimique de la couche de matériau électriquement conducteur.

5. Procédé de fabrication de circuits imprimés flexibles pour modules de carte à puce selon l'une des revendications précédentes, comprenant une étape de perforation de trous (42) à travers l'ensemble comprenant au moins deux strates de matériau diélectrique de couleurs différentes, préalablement à une étape de lamination de la couche de matériau électriquement conducteur, au cours de laquelle au moins certains des trous (42) sont au moins partiellement obturés par la couche de matériau électriquement conducteur pour former des trous borgnes ou des trous rendus conducteurs par électrodéposition d'un matériau conducteur sur leur paroi respective.

6. Procédé de fabrication de circuits imprimés flexibles pour modules de carte à puce selon l'une des revendications précédentes, dans lequel l'ensemble comprenant au moins deux strates de matériau diélectrique de couleurs différentes est réalisé en déposant au moins une couche de renfort (68) entre deux strates.

7. Circuit imprimé flexible pour module de carte à puce comprenant un matériau complexe présentant deux faces principales, ce matériau complexe formant un ensemble comprenant au moins deux strates de matériau diélectrique de couleurs différentes et comportant en outre au moins une couche de matériau électriquement conducteur (60), au contact d'une strate de l'ensemble comprenant au moins deux strates de matériau diélectrique de couleurs différentes, cette strate comprenant une résine époxy, dans laquelle couche de matériau électriquement conducteur (60) sont réalisés des contacts destinés à établir une connexion électrique avec un lecteur de cartes à puce, et entre lesquels l'ensemble comprenant au moins deux strates de matériau diélectrique de couleurs différentes, est apparent sur au moins deux zones (64), **caractérisé par le fait qu'**il comporte dans l'une des deux zones (64, 65, 66, 67) laissées apparentes, au moins la couleur de l'une des strates de matériau diélectrique, et dans l'autre des deux zones (64, 65, 66, 67) laissées apparentes, au moins la couleur d'une autre strate de matériau diélectrique.

8. Circuit imprimé selon la revendication 7, dans lequel le matériau complexe comprend un substrat diélectrique (40) flexible et au moins une couche de matériau diélectrique adhésif (30, 31) reposant sur le substrat diélectrique (40).

9. Circuit imprimé selon la revendication 7, dans lequel le matériau complexe comprend un substrat diélectrique (40) flexible, au moins une couche de matériau diélectrique adhésif (30, 31) et au moins une couche de renfort (68) intercalée entre le substrat diélectrique (40) flexible et la couche de matériau diélectrique adhésif (30,31).

10. Circuit imprimé selon la revendication 8 ou 9, dans lequel le matériau complexe comprend au moins deux couches de matériau diélectrique adhésif (30, 31) de couleurs apparentes différentes.

11. Circuit imprimé selon l'une des revendications 8 à 10, dans lequel chaque couche de matériau diélectrique adhésif (30, 31) a une épaisseur supérieure ou égale à 7 micromètres.

12. Module de carte à puce comprenant un circuit imprimé selon l'une des revendications 7 à 11, comprenant une puce électronique (100) et des trous (42) perforés à travers l'épaisseur de l'ensemble comprenant le substrat (40) et la ou les couches de matériau diélectrique (30, 31), et au moins partiellement obturés par la couche de matériau électriquement conducteur (60), la puce (100) étant connectée par l'intermédiaire de ces trous (42) à des contacts (15) réalisés dans la couche de matériau électriquement conducteur.

13. Module selon la revendication 12, dans lequel le matériau complexe comporte plus d'une couche de matériau diélectrique adhésif (30, 31), chaque couche de matériau diélectrique adhésif (30, 31) ayant une couleur différente.

14. Carte à puce comprenant un corps de carte, une cavité (4) formée dans le corps de carte et un module (2) logé dans la cavité (4), ce module (2) comprenant un circuit imprimé selon l'une des revendications 7 à 11, l'épaisseur totale du module (2) étant inférieure ou égale à 580µm.

## Patentansprüche

1. Verfahren zur Herstellung flexibler gedruckter Schaltungen für Chipkartenmodule (2), bei dem ein komplexes Material bereitgestellt wird, wobei dieses komplexe Material als eine dünne Platte oder ein Band mit zwei Hauptflächen vorliegt und flexibel ist, so dass es in einer Richtung senkrecht zu seinen Hauptflächen gebogen werden kann, wobei dieses komplexe Material eine Anordnung bildet, die mindestens zwei Schichten aus dielektrischem Material unterschiedlicher Farben umfasst, und wobei dieses komplexe Material ferner mindestens eine Schicht aus elektrisch leitfähigem Material (60) in Kontakt mit einer Schicht der Anordnung umfasst, die mindestens zwei Schichten aus dielektrischem Material unterschiedlicher Farben umfasst, wobei diese Schicht ein Epoxidharz umfasst, wobei Kontakte (15) in der Schicht aus elektrisch leitfähigem Material (60) hergestellt werden, wobei diese Kontakte dazu bestimmt sind, eine elektrische Verbindung mit einem Chipkartenleser herzustellen, wobei die Anordnung, die mindestens zwei Schichten aus dielektrischem Material unterschiedlicher Farben umfasst, durch die Schicht aus elektrisch leitfähigem Material (60) über mindestens einem Bereich (64) sichtbar ist, wobei dieses Herstellungsverfahren **dadurch gekennzeichnet ist, dass** es einen Vorgang umfasst, bei dem mindestens eine der zwei Schichten unterschiedlicher Farben mittels eines Laserstrahls in einem Teil des freigelegten Bereichs (64, 65, 66, 67) der Anordnung, die mindestens zwei Schichten aus dielektrischem Material unterschiedlicher Farben umfasst, graviert wird, um die Farbe der anderen der zwei Schichten unterschiedlicher Farben sichtbar zu machen.

2. Verfahren zur Herstellung flexibler gedruckter Schaltungen für Chipkartenmodule nach Anspruch 1, wobei die Anordnung, die mindestens zwei Schichten aus dielektrischem Material unterschiedlicher Farben umfasst, ein dielektrisches Substrat (40) mit mindestens einer Schicht aus dielektrischem Material (30, 31) aufweist, die auf einer der Hauptflächen des dielektrischen Substrats (40) abgeschieden ist.

3. Verfahren zur Herstellung flexibler gedruckter Schaltungen für Chipkartenmodule nach Anspruch 1 oder 2, wobei der freigelegte Bereich der Anordnung, die mindestens zwei Schichten aus dielektrischem Material unterschiedlicher Farben umfasst, durch Gravieren der Schicht aus elektrisch leitfähigem Material mittels eines Laserstrahls erhalten wird.

4. Verfahren zur Herstellung flexibler gedruckter Schaltungen für Chipkartenmodule nach Anspruch 1 oder 2, wobei der freigelegte Bereich der Anordnung, die mindestens zwei Schichten aus dielektrischem Material unterschiedlicher Farben umfasst, durch Photolithographie und elektrochemisches Ätzen der Schicht aus elektrisch leitfähigem Material erhalten wird.

5. Verfahren zur Herstellung flexibler gedruckter Schaltungen für Chipkartenmodule nach einem der vorstehenden Ansprüche, umfassend einen Schritt des Perforierens von Löchern (42) durch die Anordnung, die mindestens zwei Schichten aus dielektrischem Material unterschiedlicher Farben umfasst, vor einem Schritt der Laminierung der Schicht aus elektrisch leitfähigem Material, wobei währenddessen mindestens einige der Löcher (42) zumindest teilweise durch die Schicht aus elektrisch leitfähigem Material verschlossen werden, um Sacklöcher oder durch Elektrodeposition eines leitfähigen Materials auf ihrer jeweiligen Wand leitfähig gemachte Löcher zu bilden.

6. Verfahren zur Herstellung flexibler gedruckter Schaltungen für Chipkartenmodule nach einem der vorstehenden Ansprüche, wobei die Anordnung, die mindestens zwei Schichten aus dielektrischem Material unterschiedlicher Farben umfasst, hergestellt wird, indem mindestens eine Verstärkungsschicht (68) zwischen zwei Schichten abgeschieden wird.

7. Flexible gedruckte Schaltung für ein Chipkartenmodul, umfassend ein komplexes Material mit zwei Hauptflächen, wobei dieses komplexe Material eine Anordnung bildet, die mindestens zwei Schichten aus dielektrischem Material unterschiedlicher Farben umfasst, und ferner mindestens eine Schicht aus elektrisch leitfähigem Material (60) in Kontakt mit einer Schicht der Anordnung umfasst, die mindestens zwei Schichten aus dielektrischem Material unterschiedlicher Farben umfasst, wobei diese Schicht ein Epoxidharz umfasst, wobei in der Schicht aus elektrisch leitfähigem Material (60) Kontakte hergestellt sind, die dazu bestimmt sind, eine elektrische Verbindung mit einem Chipkartenleser herzustellen, und zwischen denen die Anordnung, die mindestens zwei Schichten aus dielektrischem Material unterschiedlicher Farben umfasst, über mindestens zwei Bereiche (64) sichtbar ist, **dadurch gekennzeichnet, dass** sie in einem der zwei freigelegten Bereiche (64, 65, 66, 67) mindestens die Farbe einer der Schichten aus dielektrischem Material aufweist und in dem anderen der zwei freigelegten Bereiche (64, 65, 66, 67) mindestens die Farbe einer anderen Schicht aus dielektrischem Material aufweist.

8. Gedruckte Schaltung nach Anspruch 7, wobei das komplexe Material ein flexibles dielektrisches Substrat (40) und mindestens eine auf dem dielektrischen Substrat (40) aufliegende dielektrische Haftschicht (30, 31) umfasst.

9. Gedruckte Schaltung nach Anspruch 7, wobei das komplexe Material ein flexibles dielektrisches Substrat (40), mindestens eine dielektrische Haftschicht (30, 31) und mindestens eine Verstärkungsschicht (68) umfasst, die zwischen dem flexiblen dielektrischen Substrat (40) und der dielektrischen Haftschicht (30, 31) angeordnet ist.

10. Gedruckte Schaltung nach Anspruch 8 oder 9, wobei das komplexe Material mindestens zwei dielektrische Haftschichten (30, 31) unterschiedlicher sichtbarer Farben umfasst.

11. Gedruckte Schaltung nach einem der Ansprüche 8 bis 10, wobei jede dielektrische Haftschicht (30, 31) eine Dicke von größer oder gleich 7 Mikrometern aufweist.

12. Chipkartenmodul, umfassend eine gedruckte Schaltung nach einem der Ansprüche 7 bis 11, umfassend einen elektronischen Chip (100) und Löcher (42), die durch die Dicke der Anordnung, umfassend das Substrat (40) und die Schicht oder die Schichten aus dielektrischem Material (30, 31), perforiert und zumindest teilweise durch die Schicht aus elektrisch leitfähigem Material (60) verschlossen sind, wobei der Chip (100) über diese Löcher (42) mit Kontakten (15) verbunden ist, die in der Schicht aus elektrisch leitfähigem Material hergestellt sind.

13. Modul nach Anspruch 12, wobei das komplexe Material mehr als eine dielektrische Haftschicht (30, 31) aufweist, wobei jede dielektrische Haftschicht (30, 31) eine unterschiedliche Farbe aufweist.

14. Chipkarte, umfassend einen Kartenkörper, eine in dem Kartenkörper ausgebildete Ausnehmung (4) und ein in der Ausnehmung (4) untergebrachtes Modul (2), wobei dieses Modul (2) eine gedruckte Schaltung nach einem der Ansprüche 7 bis 11 umfasst, wobei die Gesamtdicke des Moduls (2) kleiner oder gleich 580 µm ist.

## Claims

1. Method for manufacturing flexible printed circuits for modules (2) of smart card (1), in which a complex material is provided, this complex material being in the form of a thin sheet or a strip, with two main faces and being flexible so as to be bent in a direction perpendicular to its main faces, this complex material forming an assembly comprising at least two layers of dielectric material of different colors, and this complex material further comprising at least one layer of electrically conductive material (60) in contact with a layer of the assembly comprising at least two layers of dielectric material of different colors, this layer comprising an epoxy resin, contacts (15) being made in the electrically conductive material layer (60), these contacts being intended to establish an electrical connection with a smart card reader, the assembly comprising at least two layers of dielectric material of different colors being visible through the electrically conductive material layer (60) over at least one area (64), this manufacturing method being **characterized in that** it comprises an operation consisting of engraving at least one of the two layers of different colors using a laser beam on a portion of the exposed area (64, 65, 66, 67) of the assembly comprising at least two layers of dielectric material of different colors, so as to make visible the color of the other of the two layers of different colors.

2. Method for manufacturing flexible printed circuits for smart card modules according to claim 1, in which the assembly comprising at least two layers of dielectric material of different colors comprises a dielectric substrate (40) with at least one layer of dielectric material (30, 31) deposited on one of the main faces of the dielectric substrate (40).

3. Method for manufacturing flexible printed circuits for smart card modules according to claim 1 or 2, wherein the exposed area of the assembly comprising at least two layers of dielectric material of different colors is obtained by engraving, using a laser beam, the electrically conductive material layer.

4. Method for manufacturing flexible printed circuits for smart card modules according to claim 1 or 2, wherein the exposed area of the assembly comprising at least two layers of dielectric material of different colors is obtained by photolithography and electrochemical etching of the electrically conductive material layer.

5. Method for manufacturing flexible printed circuits for smart card modules according to one of the preceding claims, comprising a step of perforating holes (42) through the assembly comprising at least two layers of dielectric material of different colors, prior to a lamination step of the electrically conductive material layer, during which at least some of the holes (42) are at least partially filled by the electrically conductive material layer to form blind holes or holes made conductive by electrodeposition of a conductive material on their respective wall.

6. Method for manufacturing flexible printed circuits for smart card modules according to one of the preceding claims, in which the assembly comprising at least two layers of dielectric material of different colors is made by depositing at least one reinforcement layer (68) between two layers.

7. Flexible printed circuit for a smart card module comprising a complex material having two main faces, this complex material forming an assembly comprising at least two layers of dielectric material of different colors and further comprising at least one layer of electrically conductive material (60), in contact with a layer of the assembly comprising at least two layers of dielectric material of different colors, this layer comprising an epoxy resin, in which layer of electrically conductive material (60) contacts are made which are intended to establish an electrical connection with a smart card reader, and between which the assembly comprising at least two layers of dielectric material of different colors is visible over at least two areas (64), **characterized in that** in one of the two exposed areas (64, 65, 66, 67) it comprises at least the color of one of the dielectric material layers, and in the other of the two exposed areas (64, 65, 66, 67) it comprises at least the color of another dielectric material layer.

8. Printed circuit according to claim 7, in which the complex material comprises a flexible dielectric substrate (40) and at least one adhesive dielectric material layer (30, 31) resting on the dielectric substrate (40).

9. Printed circuit according to claim 7, in which the complex material comprises a flexible dielectric substrate (40), at least one adhesive dielectric material layer (30, 31) and at least one reinforcement layer (68) interposed between the flexible dielectric substrate (40) and the adhesive dielectric material layer (30, 31).

10. Printed circuit according to claim 8 or 9, in which the complex material comprises at least two adhesive dielectric material layers (30, 31) of different visible colors.

11. Printed circuit according to one of claims 8 to 10, in which each adhesive dielectric material layer (30, 31) has a thickness greater than or equal to 7 micrometers.

12. Smart card module comprising a printed circuit according to one of claims 7 to 11, comprising an electronic chip (100) and holes (42) perforated through the thickness of the assembly comprising the substrate (40) and the dielectric material layer(s) (30, 31), and at least partially filled by the electrically conductive material layer (60), the chip (100) being connected via these holes (42) to contacts (15) made in the electrically conductive material layer.

13. Module according to claim 12, in which the complex material comprises more than one adhesive dielectric material layer (30, 31), each adhesive dielectric material layer (30, 31) having a different color.

14. Smart card comprising a card body, a cavity (4) formed in the card body and a module (2) housed in the cavity (4), this module (2) comprising a printed circuit according to one of claims 7 to 11, the total thickness of the module (2) being less than or equal to 580µm.
